# EUROPÄISCHE PATENTSCHRIFT

(11) **EP 0 604 466 B1**
(45) Veröffentlichungstag und Bekanntmachung des Hinweises auf die Patenterteilung: **22.11.1995**
(21) Anmeldenummer: 92918130.3
(22) Anmeldetag: 27.08.1992
(51) Int. Cl.: G01C 17/38, G01R 33/025

(54) **VERFAHREN ZUR KOMPENSATION EINES MAGNETISCHEN STÖRFELDES IN EINEM FAHRZEUG**
PROCESS FOR COMPENSATING A MAGNETIC INTERFERENCE FIELD IN A VEHICLE
PROCEDE DE COMPENSATION D'UN CHAMP MAGNETIQUE PERTURBATEUR DANS UN VEHICULE

(30) Priorität: 17.09.1991 EP 91115776
(43) Veröffentlichungstag der Anmeldung: 06.07.1994
(60) Teilanmeldung: 95102680.6
(73) Patentinhaber: SIEMENS AKTIENGESELLSCHAFT, 80333 München (DE)
(72) Erfinder: BREHLER, Markus, D-8000 München 70 (DE); FEIGEN, Patrick, D-8000 München 71 (DE)
(86) Internationale Anmeldenummer: EP9201981
(87) Internationale Veröffentlichungsnummer: WO9306434

(56) Entgegenhaltungen:
- EP-A- 0 382 290
- EP-A- 0 451 839
- DE-A- 4 000 345
- US-A- 4 622 843
- US-A- 4 807 462

## Beschreibung

Die Erfindung bezieht sich auf ein Verfahren zur Kompensation eines magnetischen Störfeldes in einem Fahrzeug gemäß dem Oberbegriff des Anspruchs 1.

Für die Leitweglenkung eines Fahrzeuges ist es erforderlich, die Richtung des Erdmagnetfeldes in bezug auf das Fahrzeug zu ermitteln. Das Magnetfeld wird mit einem im Fahrzeug fest eingebauten Magnetometer, z.B. einer Magnetfeldsonde, gemessen. Während einer Eichfahrt, z.B. Kreisfahrt, werden die Parameter der Ortskurve, nämlich einer Ellipse, des Magnetfeldes nach einem bekannten Verfahren ermittelt. Die Parameter der elliptischen Ortskurve (E1) sind die beiden Halbachsen a und b, die Verdrehung um einen bestimmten Winkel (δ), welche die Form beschreiben, und die Verschiebung aus dem Koordinatenursprung, wie dies aus der EP-A-0 382 290 bereits bekannt ist. Diese Verschiebung wird als "Störfeldvektor" (V1) bezeichnet (Fig. 1).

Eine Analyse der gesammelten Meßdaten der Magnetfeldsonde hat ergeben, daß der Störfeldvektor (V1) sich aufgrund äußerer Einflüsse sprunghaft ändert, während die Form (a,b,δ) der Ortskurve in der Regel konstant bleibt. Solche Einflüsse sind beispielsweise das Bewegen eines Stahlschiebedaches oder eines Glasschiebedaches mit Stahlrahmen, sich ändernde Straßenneigungen, die senkrecht zur Fahrtrichtung verlaufen, das Ein- oder Ausladen metallischer Last im Fahrzeug, wie beispielsweise die Heckscheibenheizung. Diese Änderungen sind länger andauernd oder langsam verlaufend, etwa im Minutenbereich. Sie müssen von kurzfristigen Störungen bzw. Störfeldern, die von Untergrund-, Straßenbahnen oder vorbeifahrenden LKW's verursacht sind, unterschieden werden.

Es wurden daher schon verschiedene Kompensationsverfahren beschrieben. Beispielsweise ist aus der DE-OS 36 44 681 ein Navigationsverfahren für Fahrzeuge mit elektrischem Kompaß bekannt, bei dem mit einem dynamischen Nachziehverfahren hartmagnetische Einflüsse in der Umgebung des Magnetfeldsensors kompensiert werden. Bei dem bekannten Verfahren wird ein gewichteter Störfeldvektor zum Störvektor addiert. Dabei ist es jedoch nachteilig, daß die Unterscheidung zwischen kurzen und länger dauernden Störfeldern nur ausschließlich mit Hilfe des Wichtungsfaktors erfolgt. Wird der Wichtungsfaktor gemäß dem bekannten Verfahren zu 0,1 bei einer Zykluszeit von 100 msec gewählt, so gehen viele kurzfristige Störungen, wie oben erwähnt, vollständig in die Störvektorverschiebung ein und verfälschen somit das Ergebnis der Navigation nachhaltig. Wird der Wichtungsfaktor hingegen so klein gewählt, daß der obige Effekt nicht auftritt, so gehen die kurzfristigen Störfelder trotzdem, wenn auch schwächer, in das Ergebnis ein. Außerdem dauert das Nachziehen dann sehr lange, etwa im Zehn-Minuten-Bereich, so daß die Navigation unzumutbar lange gestört ist.

Aufgabe der Erfindung ist es daher, ein Verfahren zur Kompensation von magnetischen Störfeldern zu verbessern, welche durch sprunghafte Änderungen hervorgerufen werden und zu länger andauernden Störungen führen. Dabei sollen kurzfristige Störungen, die ebenfalls zu einer Änderung des gemessenen Magnetfeldes führen, unterdrückt werden, um dadurch Mißweisungen zu vermeiden.

Diese Aufgabe wird bei dem hier beschriebenen Kompensationsverfahren mit den Merkmalen des Anspruchs 1 gelöst.

Das erfindungsgemäße Verfahren weist folgende Verfahrensschritte auf:

Die Ortskurve ist von den Meßwerten der Magnetfeldsonde gebildet. Diese Meßwerte liegen auf einer Ellipse (E1). Während einer Eichfahrt werden für eine Erstkompensation die Störfeldparameter (Parameter dieser Ellipse E1) ermittelt, das sind die Mittelpunktskoordinaten (M1), die Achsen a und b und die Schräglage δ. Alle Meßwerte (elliptische Ortskurve E1) werden auf eine kreisförmige Ortskurve (Kreis K1) mit dem Radius a und dem Koordinatenursprung (0=M1) transformiert. Alle weiteren Verfahrensschritte finden in diesem transformierten System statt. Mit Filtern und durch Vertrauensbereich-Prüfungen werden kurzfristige Störfeldänderungen erkannt und die dazugehörigen Magnetfeldsonden-Meßwerte ausgesondert. Für jedes Meßwertpaket (Meßwerte X und Y) werden Winkel und Radius berechnet. Der Radius wird in einem Segmentspeicher entsprechend dem zugehörigen Winkel abgelegt. Dieser Segmentspeicher umfaßt den gesamten Winkelbereich von 0° bis 360°, wobei eine Vielzahl von Winkelbereichen, beispielsweise jeweils 15°, mit zugehörigen Speicherzellen gebildet sind. Alle Radien, die in gleiche Speicherzellen des Segmentspeichers abgelegt sind, werden gemittelt. Zusätzlich werden noch die Mittelwerte aller zu einem Winkelbereich gehörenden Meßwertpaare gebildet und abgespeichert. Sobald eine ausreichende Menge von Meßwerten vorliegt und eine bestimmte Anzahl von Winkelbereichen überstrichen ist, wird das im folgenden beschriebene Verfahren durchgeführt.

Es wird aus den gemittelten Meßwerten (X,Y) mittels einer linearen Regression eine Gerade berechnet und deren Korrelationskoeffizient mit einem empirisch ermittelten Wert verglichen. Ist der Korrelationskoeffizient größer, so wird der Schwerpunkt aller Meßwertpaare bestimmt, z.B. als Mittelwert der Schnittpunkt der Geraden mit dem Kreis. In diesem Schwerpunkt wird das Lot in Richtung des Koordinatenursprungs errichtet. Auf dem Lot wird nun der Kreisradius aufgetragen, wobei der Endpunkt den Mittelpunkt der neuen Ortskurve ergibt, so daß mit dem hierdurch erhaltenen Störfeldvektor die weitere Kompensation durchgeführt werden kann.

Dabei werden erst während einer gewissen Zeit Meßwerte gesammelt und verarbeitet, bevor der eigentliche Vorgang der Kompensations-Anpassung durchgeführt wird. Falls während dieser Phase erkennbare Störungen auftreten, wird die Meßwert-Sammelphase abgebrochen und neu begonnen. Hierbei wird der Zeitpunkt des Kompensationsverfahrens durch folgende Kriterien bestimmt:
Eine bestimmte Anzahl von Meßwerten sind eingelaufen und eine bestimmte Anzahl von Winkelsegmenten wurden beschrieben. Bei einer Verbesserung des Verfahrens werden verschiedene Kombinationen von einer bestimmten Anzahl von Meßwerten und Winkelsegmenten zugelassen, von denen mindestens eine erfüllt sein muß. Der Grund dafür besteht in folgendem Sachverhalt:
Ein Fahrzeug fährt längere Zeit im wesentlichen geradeaus, es werden viele Meßwerte in einem kleinen Winkelbereich gesammelt. In einem anderen Fall fährt ein Fahrzeug eine 90°-Kurve, wobei wenige Meßwerte in relativ viele Winkelbereiche eingetragen werden. In beiden Fällen sollte eine versuchsweise Neukompensation möglich sein.

In einer Weiterbildung des erfindungsgemäßen Verfahrens wird schon während der Datensammelphase geprüft, wie gut der aktuelle Störfeldvektor den momentanen Meßwerten entspricht, d.h. es wird die Güte des Störfeldvektors bestimmt. Dabei werden die Radien der Meßwerte mit dem Sollradius verglichen. Wird eine stärkere Abweichung festgestellt, so können die Meßwerte zwischengespeichert werden und nach der nächsten Kompensationsanpassung kann die Position rückwirkend korrigiert werden.

Anhand einer Zeichnung wird das erfindungsgemäße Verfahren erläutert, dabei zeigen
Figur 1 eine elliptische Ortskurve des Magnetfeldes und deren Verschiebung in einem kartesischen Koordinatensystem und
Figur 2 eine verschobene, auf den Kreis transformierte Ortskurve aufgrund des Störfeldes.

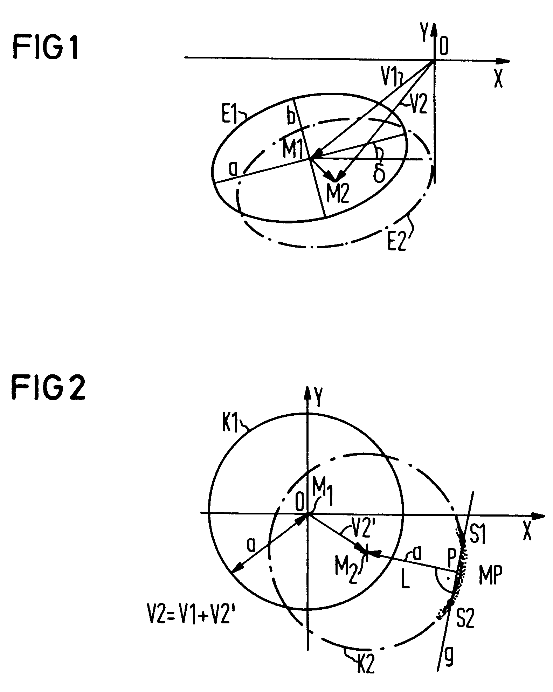

In Figur 1 ist der bekannte Eichvorgang veranschaulicht. Während einer Eichfahrt werden die Parameter (a,b,δ) der Ortskurve -Ellipse E1- des Magnetfeldes ermittelt und gespeichert. Damit ist diese Ortskurve E1 mit ihren Parametern, den Halbachsen a,b und der Winkeldrehung δ bekannt und aufgrund des Störfeldes aus den Koordinatenursprung 0 heraus verschoben, so daß vom Koordinatenursprung 0 aus zum Mittelpunkt M1 der Ellipse E1 der Störfeldvektor V1 berechnet werden kann. Eine sprunghafte Änderung des Magnetfeldes führt erneut zu einer weiteren Verschiebung der elliptischen Ortskurve, was in der Figur 1 durch die gestrichelte Ellipse E2 angedeutet ist, die dann den Mittelpunkt M2 aufweist. Aufgabe der Erfindung ist es nun, die sprunghafte Änderung des Störfeldes (Vektor M1-M2) und damit den neuen Störfeldvektor V2 zu ermitteln.

In Figur 2 ist für die Ermittlung des Störfeldvektors (V2′) zur Kompensation des Störfeldes das erfindungsgemäße Verfahren veranschaulicht. Das Verfahren basiert auf der Idee, daß ein Kreisbogen innerhalb eines kleinen Winkels als Gerade g approximiert werden kann. Wird auf diese Gerade g bzw. auf diesem Geraden-Abschnitt S1,S2 der den Meßwerten MP des Erdmagnetfeldes entspricht, im Schwerpunkt P das Lot L in Richtung des Koordinatenursprungs 0 gefällt und darauf der Radius a aus der Ortskurve K1 der Erstkompensation abgetragen, so erhält man den Mittelpunkt M2 der neuen Ortskurve K2.

Die Ortskurve K1 ist die auf den Kreis normierte Ortskurve E1 aus der Erstkompensation mit dem Mittelpunkt M1 und dem Radius a. Das sprunghaft auftretende Störfeld gibt eine Meßwertpunkte-Ansammlung MP auf einer verschobenen Ortskurve E2 (Figur 1), dem transformierten Kreis K2. Der neue Störfeldvektor (V2) ist die vektorielle Summe aus altem Störfeldvaktor (V1) und Mittelspunktsverschiebung 0-M2 (V2′). Die Meßwertspunkte MP werden statistisch an eine Gerade g angepaßt und die Korrelation dieser Geraden g wird bestimmt. Mit Hilfe der Korrelation wird die Gerade bewertet, dabei hat sich herausgestellt, daß der empirisch gefundene Wert von 0,93 als unterer Grenzwert anzusehen ist, um eine Fehlverschiebung zu vermeiden. Wird dieser Wert unterschritten, so wird das Verfahren abgebrochen und von neuem begonnen. Die Schnittpunkte S1 und S2 der Geraden g mit den Meßwertpunkten MP auf dem Kreisbogen von K2 werden berechnet und daraus der Schwerpunkt P des Geraden-Abschnittes S1,S2 (Kreissehne) bestimmt. Dann wird das Lot L durch den gefundenen Schwerpunkt P in Richtung des Ursprungs 0 gefällt. Wie bereits oben erwähnt, wird darauf der neue Mittelpunkt M2 bestimmt und somit der neue Störfeldvektor V2 erhalten.

Bei dem erfindungsgemäßen Verfahren kann aufgrund des Vergleichs der Radiuswerte aller eingehenden Magnetfeldmeßwerte mit dem Radius aus der Erstkompensation die Güte des Störfeldvektors bestimmt werden. Von dem Moment an, an dem die Güte des Störfeldvektors abnimmt, werden alle Originalmeßwerte von der Magnetfeldsonde und vom Radsensor (Wegimpulse) abgespeichert. Nach einer erfolgreichen Korrektur des Störfeldvektors, d.h. wenn die Güte des Störfeldvektors wieder hinreichend gut ist, kann aufgrund der gespeicherten Daten die Position des Fahrzeugs nachträglich kompensiert werden.

## Patentansprüche

1. Verfahren zur Kompensation eines Magnetstörfeldes in einem Fahrzeug, in dem für Navigationszwecke mittels einer Magnetfeldsonde und einer Meß- und Auswerteeinrichtung die Richtung des Erdmagnetfeldes und mit einem Radsensor die gefahrene Wegstrecke ermittelt und in einem Navigationsrechner verarbeitet werden, mit folgenden Verfahrensschritten:
aus den Meßwerten der Magnetfeldsonde wird während einer Eichfahrt (z.B. Kreisfahrt) für eine Erstkompensation ein erster Satz von Störfeldparametern ermittelt, die aus den Werten für den Störfeldvektor (V1), den Achsen (a,b) der elliptischen Ortskurve (E1) und der Schräglage (δ) dieser Ortskurve bestehen;
die bei der Eichfahrt ermittelte elliptische Ortskurve (E1) wird in eine kreisförmige Ortskurve (K1) mit einem Radius (a) und dem Kreismittelpunkt (M1) im Koordinatenursprung (0) transformiert;
während der Fahrt werden alle Meßwerte einer Transformation unter Berücksichtigung eines Satzes von Störfeldparametern unterzogen, wobei die Meßwertparameter (X,Y) Punkte einer kreisförmigen Ortskurve (K2) sind;
zu jedem transformierten Meßwertepaar (X;Y) wird der Abstand vom Nullpunkt, Radius, und der Winkel berechnet;
ein Segmentspeicher für den Bereich von 0°-360° wird definiert, wobei jede Speicherzelle einem vorgegebenen Winkelbereich bzw. Segment, z.B. 15°, entspricht;
die berechneten Radiuswerte und die kreistransformierten Meßwertpaare (MP) werden in die ihrem Winkel entsprechenden Speicherzellen eingemittelt;
**gekennzeichnet durch** folgende Verfahrensschritte:
aus den gemittelten X- und Y-Werten wird mittels einer linearen Regression eine Gerade (g) berechnet;
der Korrelationskoeffizient dieser Geraden (g) wird bestimmt und mit einer empirisch gefundenen Schwelle verglichen;
falls der Korrelationskoeffizient größer als diese Schwelle ist, wird der Schwerpunkt (P) des Geraden-Abschnitts (S1,S2) bestimmt, der durch die Meßwertepaare (MP) in den Segmentspeicher gegeben ist; in diesem Schwerpunkt (P) wird das Lot (L) auf der Geraden (g) in Richtung des Koordinatenursprungs (0) errichtet; auf dem Lot (L) wird der Kreisradius (a) aufgetragen, wobei dessen Endpunkt den Mittelpunkt (M2) der neuen Ortskurve (Kreis K2) bildet und wobei ein neuer Störfeldvektor (V2) aus der Summe des bisherigen Störfeldvektors (V1) und der Verschiebung des Mittelpunktes (0-M2, V2′) ermittelt wird, und wobei der neue Störfeldvektor (V2) in den Satz der Störfeldparameter aufgenommen und bei der Transformation von Meßwerten berücksichtigt wird.

2. Verfahren nach Anspruch 1,
**dadurch gekennzeichnet,** daß der neue Störfeldvektor (V2) nur berechnet wird, wenn eine Mindestanzahl von Meßwerten überschritten und gleichzeitig eine Mindestanzahl von Winkelbereichen im Segmentspeicher beschrieben ist.

3. Verfahren nach Anspruch 2,
**dadurch gekennzeichnet,** daß eine von mehreren vorgegebenen Kombinationen von Meßwertmindestzahl und Mindestanzahl von beschriebenen Winkelbereichen im Segmentspeicher erfüllt sein muß.

4. Verfahren nach einem der vorhergehenden Ansprüche,
**dadurch gekennzeichnet,** daß aus dem Vergleich der Radiuswerte aller eingehenden Magnetfeld-Meßwerte mit dem Radius der Ortskurve aus der Erstkompensation die Güte des Störfeldvektors bestimmt wird und bei der Abnahme der Güte unter einem bestimmten Wert alle originalen Meßwerte von der Magnetfeldsonde und vom Radsensor, Wegimpulse, gespeichert werden, um nachträglich mit dem neuen Störfeldvektor die Fahrzeugposition unter Ausnutzung der gespeicherten Daten zu korrigieren.

## Claims

1. Process for compensating for a magnetic interference field in a vehicle, in which, for navigation purposes, the direction of the earth's magnetic field is determined by means of a magnetic field probe and a measuring and evaluating device and the path distance travelled is determined by a wheel sensor and these are processed in a navigation computer, said process comprising the following process steps:
during a calibration run (for example circular run) for initial compensation, a first set of interference field parameters is determined from the measurements of the magnetic field probe, which parameters comprise the values for the interference field vector (V1), the axes (a,b) of the elliptical locus curve (E1) and the oblique position (δ) of this locus curve;
the elliptical locus curve (E1) determined during the calibration run is transformed into a circular locus curve (K1) with a radius (a) and the circle centre (M1) at the coordinate origin (0);
during travel, all of the measurements are subjected to a transformation taking account of a set of interference field parameters, the measurement parameters (X, Y) being points on a circular locus curve (K2);
for each transformed pair of measurements (X; Y), the distance from the origin, radius, and the angle are calculated;
a segmented memory for the range of 0° - 360° is defined, in which each memory cell corresponds to a predetermined angular region or segment, for example 15°;
the calculated radius values and the circular-transformed pairs of measurements (MP) are averaged and entered in the memory cells corresponding to their angle;
characterized by the following process steps:
a straight line (g) is calculated from the averaged X and Y values by means of linear regression;
the correlation coefficient of this straight line (g) is determined and compared with an empirically found threshold;
if the correlation coefficient is greater than this threshold, the centre (P) of that straight line section (S1,S2) is determined, which is given by the pairs of measurements (MP) in the segmented memory; the perpendicular (L) to the straight line (g) towards the coordinate origin (O) at this centre (P) is constructed; the circle radius (a) is plotted on the perpendicular (L), the end point of this radius forming the centre (M2) of the new locus curve (circle K2), and a new interference field vector (V2) being determined from the sum of the previous interference field vector (V1) and the displacement of the centre (0-M2, V2′), and the new interference field vector (V2) being included in the set of interference field parameters and being taken into account during the transformation of measurements.

2. Process according to Claim 1, characterized in that the new interference field vector (V2) is calculated only if a minimum number of measurements is exceeded and at the same time a minimum number of angular regions is described in the segmented memory.

3. Process according to Claim 2, characterized in that one of a plurality of predetermined combinations of minimum number of measurements and minimum number of described angular regions in the segmented memory must be satisfied.

4. Process according to one of the preceding claims, characterized in that the quality of the interference field vector is determined from the comparison of the radius values of all participating magnetic field measurements with the radius of the locus curve obtained from the initial compensation and, in the event of the quality declining to below a specified value, all the original measurements from the magnetic field probe and from the wheel sensor, track pulses, are stored, in order subsequently to correct the vehicle position using the new interference field vector, with the utilization of the stored data.

## Revendications

1. Procédé pour compenser un champ magnétique parasite dans un véhicule, dans lequel, on détermine, pour se diriger, la direction du champ magnétique terrestre à l'aide d'une sonde de champ magnétique et d'un dispositif de mesure et d'exploitation et, par un capteur de roue, la distance parcourue, on les traite dans un calculateur embarqué, comportant les étapes opératoires suivantes :
on détermine à partir des valeurs de mesure de la sonde de champ magnétique un premier ensemble de paramètres du champ parasite, qui sont constitués des valeurs du vecteur de champ parasite (V1), des axes (a,b) du lieu géométrique elliptique (E1) et de la position oblique (δ) de ce lieu géométrique, pendant un projet d'étalonnage (par exemple déplacement circulaire) pour une compensation initiale;
on transforme le lieu géométrique elliptique (E1) déterminé lors du trajet d'étalonnage en un lieu géométrique circulaire (K1) de rayon (a) et dont le centre (M1) est à l'origine (O) des coordonnées;
pendant le trajet, on soumet les valeurs de mesures à une transformation en tenant compte d'un ensemble de paramètres du champ parasite, les paramètres (X,Y) des valeurs de mesure étant des points d'un lieu géométrique circulaire (K2);
on calcule la distance au point zéro, le rayon et l'angle pour chaque couple transformé de valeurs de mesure (X;Y);
on définit une mémoire de segments pour la plage de 0° à 360°, chaque cellule de la mémoire correspondant à une plage angulaire ou à un segment angulaire prédéterminé, par exemple 15°;
on fait la moyenne des valeurs calculées du rayon et des couples de valeurs de mesure (MP) transformées en cercle dans les cellules de mémoire correspondant à leur angle;
caractérisé par les étapes opératoires suivantes :
on calcule une droite (g) au moyen d'une régression linéaire à partir des valeurs moyennes de X et Y;
on détermine le coefficient de corrélation de cette droite (g) et on le compare à un seuil trouvé de façon empirique;
si le coefficient de corrélation est supérieur à ce seuil, on détermine le barycentre (P) du segment de droite (S1,S2), qui est défini par les couples de valeurs de mesure (MP) dans la mémoire de segments; en ce barycentre (P) on élève la perpendiculaire (L) à la droite (g) en direction de l'origine (O) des coordonnées; on porte le rayon (a) du cercle sur la perpendiculaire (L), le point d'extrémité de ce rayon formant le centre (M2) du nouveau lieu géométrique (cercle K2), on détermine un nouveau vecteur du champ parasite (V2) à partir de la somme du vecteur présent jusqu'alors (V1) du champ parasite et du décalage du centre (O-M2, V2′), on enregistre le nouveau vecteur (V2) du champ parasite dans l'ensemble des paramètres du champ parasite et on en tient compte lors de la transformation de valeurs de mesure.

2. Procédé suivant la revendication 1, caractérisé par le fait qu'on ne calcule le nouveau vecteur (V2) du champ parasite que lorsqu'un nombre minimum de valeurs de mesure est dépassé et que simultanément un nombre minimal de plages angulaires est enregistré dans la mémoire de segments.

3. Procédé suivant la revendication 2, caractérisé par le fait qu'il faut que l'une parmi plusieurs combinaisons prédéterminées d'un nombre minimum de valeurs de mesure et d'un nombre minimum de plages angulaires décrites dans la mémoire de segments soit satisfaite.

4. Procédé suivant l'une des revendications précédentes, caractérisé par le fait que l'on détermine la qualité du vecteur du champ parasite par comparaison des valeurs du rayon de toutes les valeurs de mesure intervenant du champ magnétique au rayon du lieu géométrique obtenu à partir de la compensation initiale et dans le cas où la qualité passe au-dessous d'une valeur déterminée, on mémorise toutes les valeurs initiales de mesure de la sonde de champ magnétique et du capteur de roue, à savoir des impulsions de déplacement. pour corriger ultérieurement la position du véhicule par le nouveau vecteur du champ parasite, en exploitant les données mémorisées.
